# EUROPEAN PATENT SPECIFICATION

(11) **EP 0 364 780 B1**
(45) Date of publication and mention of the grant of the patent: **12.03.1997**
(21) Application number: 89117934.3
(22) Date of filing: 28.09.1989
(51) Int. Cl.: H01L 31/0224, H01L 31/075, H01L 31/20

(54) **Solar cell with a transparent electrode**
Sonnenzelle mit einer durchsichtigen Elektrode
Cellule solaire comportant une éléctrode transparente

(30) Priority: 30.09.1988 JP 248452/88; 30.09.1988 JP 248453/88; 30.09.1988 JP 248454/88
(43) Date of publication of application: 25.04.1990
(73) Proprietor: KANEGAFUCHI KAGAKU KOGYO KABUSHIKI KAISHA, Kita-ku Osaka-shi (JP)
(72) Inventor: Asaoka, Keizo, Kobe-shi Hyogo-ken (JP); Tsuge, Kazunori, Kobe-shi Hyogo-ken (JP); Tawada, Yoshihisa, Kobe-shi Hyogo-ken (JP)
(74) Representative: Türk, Gille, Hrabal, Leifert

(56) References cited:
- EP-A- 0 221 523
- EP-A- 0 234 222
- US-A- 4 559 552
- THIN SOLID FILMS, vol. 88, no. 2, February 1982, Lausanne CH, pp. 93-100; E. SHANTHI et al.: "Dopant effects in sprayed tin oxide films"

## Description

The present invention relates to a semiconductor device, and more particularly to a semiconductor of which characteristics are improved. EP-A-0 221 523 concerns a semiconductor device comprising a SnO₂ transparent electrode, a highly doped amorphous SiC-H layer of p-type conductivity, a p-type semiconductor layer, an i-type semiconductor layer, a n-type semiconductor layer and a back electrode. It is known that when a solar cell is formed on a glass substrate having textured surface characteristics of solar cells are improved since light is scattered by textured surface, and light absorption in the solar cell is increased. It is also known that when thickness of SnO₂ film which is used as transparent conductive film (transparent electrode) is increased, relief of peaks and troughs thereof increases. Photoelectric conversion efficiency (hereinafter referred to as FF), however, lowers very much when relief of peaks and troughs of glass substrate is made too large since the ratio of internal series resistance of the solar cell becomes small. The size of relief of glass substrate is usually represented by the Haze ratio. It is defined by the following formula:$\text{Haze ratio =} \frac{\text{Scatterd light}}{\text{Transmitted light}} \text{x 100 [%]}$

When the of SnO₂ film becomes too thick, light absorption by SnO₂ itself becomes large and the effect of enhancement of the light absorption by textured surface is cancelled, so that efficiency of solar cell is decreased. As a result, a transparent conductive film having a thickness between 500 nm (5000 Å) and 700 nm (7000 Å) and a dopant density between 1 and 2 weight % is normally employed for a conventional solar cell.

The light absorption coefficient of a transparent conductive film is lowered by decreasing the content of dopant, whereby the characteristics of the solar cell are improved without increasing the light absorption by the transparent electrode even if a solar cell having a thick transparent conductive film is employed.

The characteristics of a solar cell having a low doped transparent conductive film, however, are not improved so much, because FF decreases accompanying with the increase of the contact resistance between the transparent electrode and the first layer of the amorphous semiconductor layers. The first layer of the amorphous semiconductor layer means, for example, p-type layer when p-type, i-type and n-type semiconductor layers are formed on the transparent electrode in this order.

The output current of a multi-junction solar cell wherein a number of amorphous semiconductor layers are stacked in order to get high output current is (1/number of blocks) and the output loss is (1/number of blocks)² of those of single-junction type solar cell respectively, so that transparent electrodes having higher resistance can be employed. The resistivity of a transparent electrode is normally controlled by the thickness thereof, i.e. the resistivity increases in accordance with the decrease of thickness.

As a result, it is understandable that thinner transparent electrode can be employed for multi-junction solar cell as compared with single-junction solar cell. It is expected that the output power is increased if a thinner transparent electrode is employed since light absorption by the transparent electrode is decreased.

The output power of a solar cell employing a thinner transparent electrode, however, is not increased as expected, because as mentioned above the light scattering effect of textured surface of transparent electrode lessens in accordance with the decrease of the transparent electrode thickness.

Taking the above mentioned matters into consideration, it is an object of the present invention to provide a semiconductor device in which the light absorption in the transparent electrode is improved.

Further, it is an object of the present invention to provide a semiconductor device in which the contact resistance between the transparent electrode and the amorphous semiconductor layers is lowered.

Still further, it is an object of the present invention to provide a multi-junction solar cell in which the output power is enhanced. A semiconductor device of the present invention comprises:
(a) a transparent electrode (2) comprising SnO₂;
(b) at least one amorphous semiconductor layer (3) having pin-layers or nip-layers;
(c) a back electrode (4);
wherein the transparent electrode (2), the amorphous semiconductor layer (3) and the back electrode (4) are formed on a glass substrate (1) in this order; the dopant density of the transparent electrode is not more than 0.5 weight %, and its sheet resistance is not more than 40Ω/□ and wherein an amorphous high dopant density semiconductor layer (5) is sandwiched between the transparent electrode (2) and the semiconductor layer (3).

It is preferable that the amorphous high dopant density semiconductor (5) layer which is sandwiched between the transparent electrode (2) and the semiconductor layers (3) has the same conductivity type as and a higher dopant density higher than that of the layer of the pin-layers or nip-layers which is faced to the transparent electrode.

In the semiconductor device of the present invention, the dopant density of transparent electrode is limited to not more than 0.5 weight %, so that light absorption by the transparent electrode can be lowered.

Since resistivity can be increased by lowering dopant quantity, it is not necessary for multi-junction solar cell to employ thin film transparent electrode. As a result, a lowering of the light scattering effect in the transparent conductive film can be avoided.

According to the present invention wherein a high dopant density semiconductor layer is sandwiched between the transparent electrode and the semiconductor layers, the contact resistance is decreased resulting in enhanced efficiency of single-junction solar cell.
Figs. 2 and 4 are schematic illustrations of the aspects of the present invention respectively;
Fig. 3 is a V-I characteristic diagram of example 1 and comparative examples 1 to 2; and
Fig. 5 is a V-I characteristic diagram of example 2 and comparative examples 3 to 4.

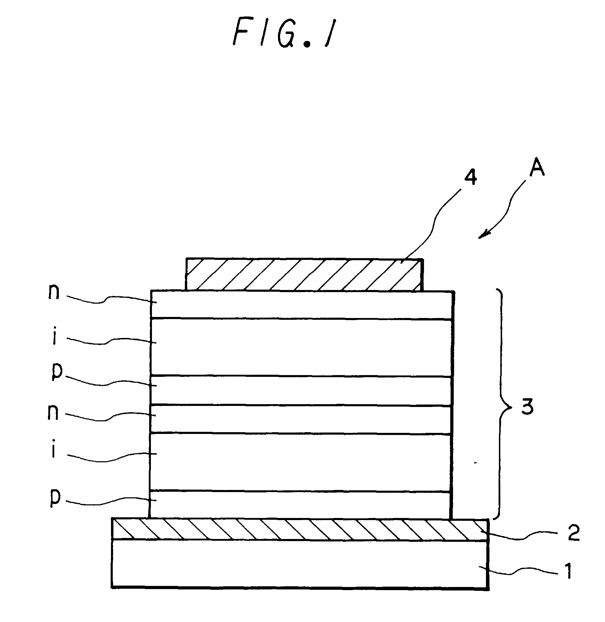

Referring now to the drawings for a more complete understanding of the present invention, there is disclosed an usual semiconductor device in Fig. 1.

In Fig. 1, A shows a semiconductor device comprising a glass substrate 1, a transparent electrode 2 comprising SnO₂, semiconductor layers 3 and a back electrode 4.

The transparent electrode 2 comprising SnO₂ is formed on the glass substrate 1 by CVD method and the like. The thickness of transparent electrode 2 is between 500 nm (5000 Å) and 2000 nm (20000 Å), preferably 500 nm (5000 Å) and 1500 nm (15000 Å). Dopant density of the electrode film is not more than 0.5 weight %. Aℓ, Sb and F can be adopted as dopant. Sheet resistance of transparent electrode 2 depends on the dopant content and the thickness thereof.

On the transparent electrode 2, a number of semiconductor layers 3, comprising pin-type or nip-type amorphous semiconductor layers stacked by ordinary methods such as glow discharge decomposition method, are formed. Fig. 1 shows a model where two pin-type amorphous semiconductor layers are formed, however, there is no limitation to the number of semiconductor layers.

In the present invention, amorphous semiconductor represents semiconductor comprising only amorphous semiconductor and semiconductor comprising amorphous semiconductor containing crystallite substrate. a-SiH; a-SiH containing C, Ge, Sn or F; or µC-SiH(microcrystalline) and the like are enumerated as concrete examples of amorphous semiconductor.

On the semiconductor layers 3, the back electrode 4 comprising Aℓ, Ag, Mo, Cr, Ni and so on is formed.

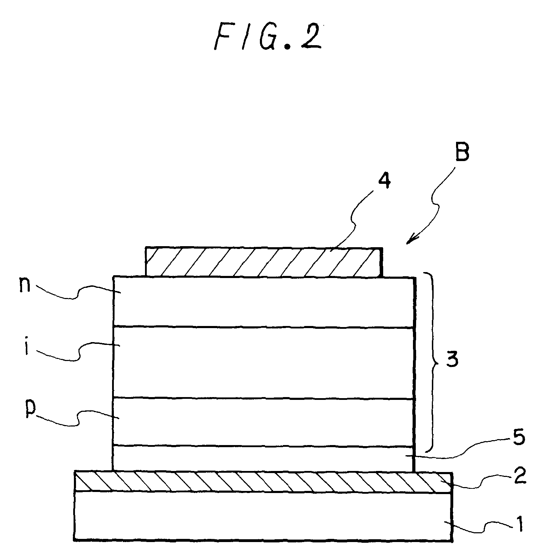

Fig. 2 is a schematic illustration of an embodiment of the present invention. The semiconductor device B comprises a glass substrate 1, a transparent electrode 2 comprising SnO₂, amorphous semiconductor layers 3 and a back electrode 4, wherein a high dopant density layer 5 is sandwiched between the transparent electrode 2 and the semiconductor layers 3.

The sheet resistance of transparent electrode is not more than 40 Ω/□, in order to avoid decreasing efficiency. It is preferably between 10 and 40 Ω/□, since if it is less than 10 Ω/□ absorption loss by added dopant cannot be neglected.

The conductivity of the high dopant density layer 5 is same as that of the layer of semiconductor layers 3 which contacts thereto. Even if the dopant density in the SnO₂ layer comprising the transparent electrode 2 is decreased, the contact resistance between the transparent electrode 2 and the amorphous semiconductor layers 3 can be lowered by providing the layer 5.

When the dopant density in SnO₂ is decreased and is not more than 0.5 weight % and the thickness of the transparent electrode 2 is designed to be about 1000 nm (10000 Å), the light absorption in the transparent electrode (SnO₂) 2 is nearly equal to that of a transparent electrode having a dopant density of 1 weight % and a thickness of 500 nm (5000 Å). In this case, the characteristic of the device whose transparent electrode thickness is 1000 nm (10000 Å) is improved since size of relief of the transparent electrode of 1000 nm (10000 Å) thickness is higher than that of 500 nm (5000 Å) thickness.

On the high dopant density layer 5, pin-type or nip-type amorphous semiconductor layers 3 are formed by ordinary methods such as glow discharge decomposition method. Fig. 2 shows a model where a pin-type is formed.

On the amorphous semiconductor layers 3, a back electrode 4 comprising Aℓ, Ag, Mo, Cr, Ni and the like is formed.

### Example 1

On a glass substrate with 1.1 mm thickness, a transparent electrode with a thickness of 1000 nm (10000 Å) comprising SnO₂ (0.1 weight % of fluorine was added) was formed by CVD method.

On the transparent electrode a high dopant density layer with a thickness of 5 nm (50 Å) was formed by plasma CVD method by feeding SiH₄: 10 SCCM; CH₄: 20 SCCM; and B₂H₆: 300 SCCM.

By plasma CVD method, p-type semiconductor layer of 15 nm (150 Å) thickness by feeding SiH₄: 10 SCCM, CH₄: 20 SCCM and B₂H₆: 100 SCCM; i-type layer of 500 nm (5000 Å) thickness by feeding SiH₄: 100 SCCM; and n-type layer of 30 nm (300 Å) thickness by feeding SiH₄: 10 SCCM and PH₃: 200 SCCM were formed in this order on the high dopant density layer.

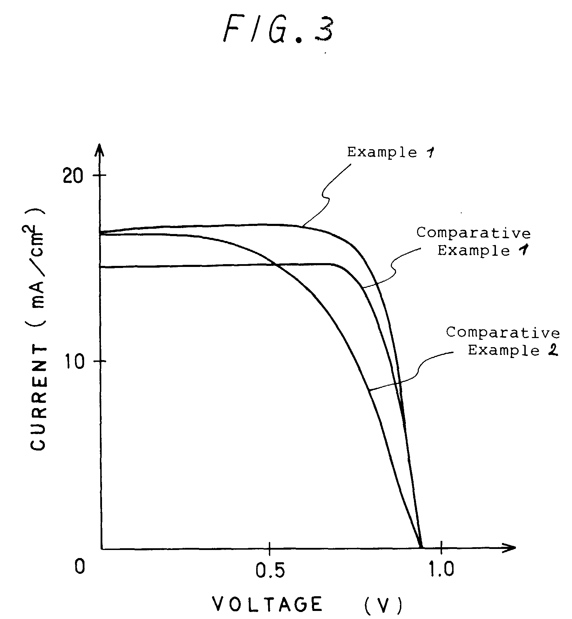

A back electrode comprising Aℓ of 1 µm thickness on the semiconductor layers was formed on the semiconductor layers by vacuum evaporation method. V-I characteristic of the obtained semiconductor device was measured under AM-1 solar-simulator of 100 mW/cm² light intensity. The result is shown in Fig. 3.

### Comparative Example 1

A semiconductor device was made in the same manner as those of Example 1 except that the thickness of transparent electrode was 500 nm (5000 Å) and that the dopant density was 1.5 weight % without a high dopant density layer. V-I characteristic was measured in the same manner as those in Example 1. The result is shown in Fig. 3.

### Comparative Example 2

A semiconductor device was made in the same manner as those of Example 1 except that a high dopant density layer was not provided. V-I characteristic was measured in the same manner as those in Example 1. The result is shown in Fig. 3.

From Fig. 3, it is understandable that efficiency of the semiconductor device of the present invention is improved.

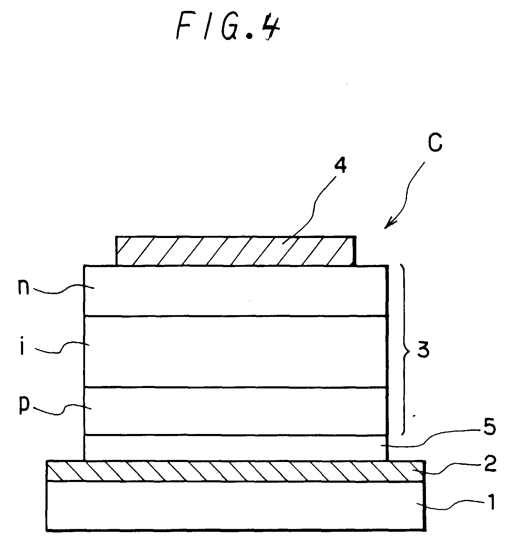

Fig. 4 is a schematic illustration of another semiconductor device according to the present invention. The semiconductor device C comprises a glass substrate 1, a 35 transparent electrode 2 comprising SnO₂, semiconductor layers 3 and a back electrode 4, wherein a high dopant density layer 5 is sandwiched between the transparent electrode 2 and the semiconductor layers 3.

Textured surfaces are provided on the surface of the glass substrate 1, for example, by SiO₂ coating. There is no limitation to the size of relief. In this specification, the size of relief means mean value which is obtained by subtracting troughs from peaks. When the difference is less than 100 nm (1000 Å), effect of light scattering becomes small. When the difference exceed 1000 nm (10000 Å), short circuit is liable to occur since normal film thickness of solar cell is between 500 nm (5000 Å) and 1000 nm (10000 Å). Therefore, it is preferable that the difference is between 100 nm (1000 Å) and 1000 nm (10000 Å).

On the transparent electrode 2, a high dopant density semiconductor layer 5 is formed like Example 1.

As is stated in Example 1, when dopant density of SnO₂ is decreased and is not more than 0.5 weight % and the thickness of transparent electrode 2 is designed to be about 1000 nm (10000 Å), the light absorption in the transparent electrode (SnO₂) 2 is nearly equal to that of a transparent electrode having a dopant density of 1 weight % and a thickness of 500 nm (5000 Å). With the transparent electrode of Fig. 4, no decrease of FF is detected for a substrate with over 40 % Haze ratio.

On the high dopant density layer 5, an amorphous semiconductor layer 3 and a back electrode 4 are formed like Example 1. Fig. 4 shows a model where pin-type is formed.

### Example 2

On a glass substrate with 1.1 mm thickness, having a textured surface (size of relief is about 500 nm (5000 Å)) formed by coating with SiO₂, a transparent electrode having a thickness of 1000 nm (10000 Å) comprising SnO₂ (0.1 weight % of fluorine was added), was formed by CVD method.

On the transparent electrode, a high dopant density layer of which thickness was 5 nm (50 Å) was formed by plasma CVD method by feeding SiH₄: 10 SCCM; CH₄: 20 SCCM; and B₂H₆: 300 SCCM.

By plasma CVD method, a p-type semiconductor layer of 15 nm (150 Å) thickness by feeding SiH₄: 10 SCCM, CH₄: 20 SCCM and B₂H₆: 100 SCCM; a i-type layer of 500 nm (5000 Å) thickness by feeding SiH₄: 100 SCCM; and a n-type layer of 30 nm (300 Å) thickness by feeding SiH₄: 10 SCCM and PH₃: 200 SCCM were formed in this order on the high dopant density layer.

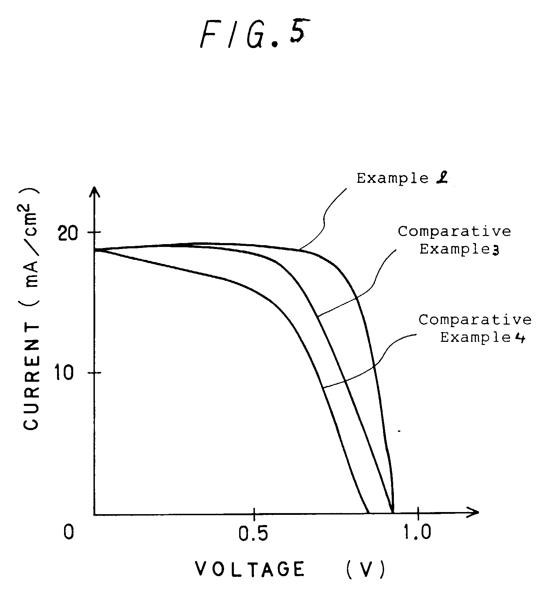

A back electrode comprising Aℓ of 1 µm thickness was formed on the semiconductor layers by vacuum evaporation method. V-I characteristic of the obtained semiconductor device was measured under AM-1 solar simulator of 100 mW/cm² light intensity. The result is shown in Fig. 5.

### Comparative Example 4

A semiconductor device was made in the same manner as those of Example 2 except that the thickness of the transparent electrode was 500 nm (5000 Å) and that the dopant density was 1.5 weight % without a high dopant density layer. The V-I characteristic was measured in the same manner as that in Example 2. The result is shown in Fig. 5.

### Comparative Example 5

A semiconductor device was made in the same manner as those of Example 2 except that a high dopant density layer was not provided. The V-I characteristic was measured in the same manner as that in Example 2. The result is shown in Fig. 5.

From Fig. 5, it is understandable that efficiency of the semiconductor device of the present invention is improved.

According to the present invention, characteristics of solar cell can be improved.

## Claims

1. A semiconductor device comprising:
(a) a transparent electrode (2) comprising SnO₂;
(b) at least one amorphous semiconductor layer (3) having pin-layers or nip-layers;
(c) a back electrode (4),
wherein the transparent electrode (2), the amorphous semiconductor layer (3) and the back electrode (4) are formed on a glass substrate (1) in this order, the dopant density of the transparent electrode is not more than 0.5 weight %, and its sheet resistance is not more than 40 Ω/□ and wherein an amorphous high dopant density semiconductor layer (5) is sandwiched between the transparent electrode (2) and the amorphous semiconductor layer (3).

2. A semiconductor device according to claim 1, wherein the amorphous high dopant density semiconductor layer (5) which is sandwiched between the transparent electrode (2) and the semiconductor layers (3) has the same conductivity type as and a higher dopant density than that of the layer of the pin-layers or nip-layers which is faced to the transparent electrode.

3. A semiconductor device according to claim 1 to 2, wherein the layer of semiconductor layers (3) which is faced to the transparent electrode (2) comprises a-SiC:H.

4. A semiconductor device according to claim 1 to 3, wherein the dopant of transparent electrode (2) is selected from the group consisting of Al, Sb and F.

5. A semiconductor device according to claim 1 to 4, wherein the glass substrate (1) has textured surface and size of relief is between 100 nm (1000 Å) and 1000 nm (10000 Å).

6. A semiconductor device according to claim 1 to 5, wherein thickness of transparent electrode (2) is between 500 nm (5000 Å) and 2000 nm (20000 Å).

7. A semiconductor device according to claim 1 to 6, wherein sheet resistance is between 10 Ω/□ and 40 Ω/□.

8. A multi-junction solar cell comprising a semiconductor device according to any of the claims 1 to 7.

## Patentansprüche

1. Halbleiter-Vorrichtung, umfassend:
(a) eine SnO₂ umfassende transparente Elektrode (2);
(b) mindestens eine amorphe Halbleiter-Schicht (3) mit pin-Schichten oder nip-Schichten;
(c) eine Rückseitenelektrode (4),
wobei die transparente Elektrode (2) die amorphe Halbleiter-Schicht (3) und die Rückseiten-Elektrode (4) in dieser Reihenfolge auf einem Glassubstrat (1) angeordnet sind, die Dotierungsmittel-Dichte der transparenten Elektrode nicht größer ist als 0,5 Gew.-%, und ihr Folienwiderstand nicht größer ist als 40 Ω/□, und wobei eine amorphe Halbleiter-Schicht mit hoher Dotierungsmitteldichte (5) zwischen den transparenten Elektrode (2) und der amorphen Halbleiter-Schicht (3) sandwichartig angeordnet ist.

2. Halbleiter-Vorrichtung nach Anspruch 1, wobei die amorphe Halbleiterschicht mit hoher Dotierungsmitteldichte (5), die sandwichartig zwischen der transparenten Elektrode (2) und der Halbleiter-Schicht (3) angeordnet ist, denselben Leitfähigkeits-Typ und eine höhere Dotierungsmitteldichte aufweist als die Schicht der pin-Schichten oder der nip-Schichten, die auf der Seite der transparenten Elektrode angeordnet sind.

3. Halbleiter-Vorrichtung nach Anspruch 1 oder 2, wobei die Schicht aus Halbleiter-Schichten (3), die auf der Seite der transparenten Elektrode (2) angeordnet ist, a-SiC:H umfaßt.

4. Halbleiter-Vorrichtung nach Anspruch 1 oder 3, wobei das Dotierungsmittel der transparenten Elektrode (2) aus der aus Al, Sb und F bestehenden Gruppe ausgewählt wird.

5. Halbleiter-Vorrichtung nach Anspruch 1 bis 4, wobei das Glassubstrat (1) eine strukturierte Oberfläche besitzt und die Reliefgröße zwischen 100 nm (1000 Å) und 1000 nm (10000 Å) liegt.

6. Halbleiter-Vorrichtung nach Anspruch 1 bis 5, wobei die Dicke der transparenten Elektrode (2) zwischen 500 nm (5000 Å) und 2000 nm (20000 Å) liegt.

7. Halbleiter-Vorrichtung nach Anspruch 1 bis 6, wobei der Folienwiderstand zwischen 10 Ω/□ und 40 Ω/□ liegt.

8. Vielfachkontaktsolarzelle, umfassend eine Halbleiter-Vorrichtung nach einem der Ansprüche 1 bis 7.

## Revendications

1. Dispositif à semi-conducteurs comprenant :
(a) une électrode transparente (2) comprenant du SnO₂ ;
(b) au moins une couche à semi-conducteurs amorphe (3) comportant des couches PIN ou des couches NIP ;
(c) une électrode de retour (4),
dans lequel l'électrode transparente (2), la couche à semi-conducteurs amorphe (3) et l'électrode de retour (4) sont formées sur un substrat de verre (1) dans cet ordre, la densité de dopage de l'électrode transparente n'est pas supérieure à 0,5 % en poids, et sa résistance série n'est pas supérieure à 40 Ω/□, et dans lequel une couche à semi-conducteurs amorphe à densité de dopage élevée (5) est prise en sandwich entre l'électrode transparente (2) et la couche à semi-conducteurs amorphe (3)

2. Dispositif à semi-conducteurs selon la revendication 1, dans lequel la couche à semi-conducteurs amorphe à densité de dopage élevée (5), qui est prise en sandwich entre l'électrode transparente (2) et la couche à semi-conducteurs (3), a le même type de conductivité et une densité de dopage plus élevée que ceux de la couche des couches PIN ou des couches NIP qui fait face à l'électrode transparente.

3. Dispositif à semi-conducteurs selon les revendications 1 et 2, dans lequel la couche des couches à semi-conducteurs (3) qui fait face à l'électrode transparente (2) comprend un SiC:H.

4. Dispositif à semi-conducteurs selon les revendications 1 à 3, dans lequel l'agent de dopage de l'électrode transparente (2) est choisi à partir du groupe constitué de Al, Sb et F.

5. Dispositif à semi-conducteurs selon les revendications 1 à 4, dans lequel le substrat en verre a une surface texturée et la hauteur du relief est entre 100 nm (1000 Å) et 1000 nm (10000 Å).

6. Dispositif à semi-conducteurs selon les revendications 1 à 5, dans lequel l'épaisseur de l'électrode transparente est entre 500 nm (5000Å) et 2000 nm (20000 Å).

7. Dispositif à semi-conducteurs selon les revendications 1 à 6, dans lequel la résistance série est entre 10 Ω/□ et 40 Ω/□.

8. Une cellule solaire à plusieurs jonctions comprenant un dispositif à semi-conducteurs selon l'une quelconque des revendications 1 à 7.
